## Europäisches Patentamt
(19) **European Patent Office**
**Office européen des brevets**

(11) Publication number: **0 012 954**
**B1**

(12) **EUROPEAN PATENT SPECIFICATION**

(45) Date of publication of patent specification: **09.02.83**

(51) Int. Cl.³: **H 01 J 37/34, C 23 C 15/00**

(21) Application number: **79105177.4**

(22) Date of filing: **14.12.79**

(54) **Bias sputter deposition apparatus and its method of use.**

(30) Priority: **22.12.78 US 972593**

(43) Date of publication of application:
**09.07.80 Bulletin 80/14**

(45) Publication of the grant of the patent:
**09.02.83 Bulletin 83/6**

(84) Designated Contracting States:
**DE FR GB**

(56) References cited:
**US - A - 2 456 795**
**US - A - 3 676 320**
**US - A - 4 013 532**

**IBM TECHNICAL DISCLOSURE BULLETIN, vol. 21, no. 12, May 1979.**
**W. C. LESTER et al., "Improved RF/DC hub assembly", page 4993.**

**IBM TECHNICAL DISCLOSURE BULLETIN, vol. 11, no. 11, April 1969.**
**D. R. ROGALLA, "Coating magnetic storage disko", page 1611.**

(73) Proprietor: **International Business Machines Corporation**
**Armonk, N.Y. 10504 (US)**

(72) Inventor: **Kennedy, Thomas Nolan**
**6897 Campisi Court**
**San Jose California 95120 (US)**
Inventor: **McDonough, George William**
**912 Rose Blossom Drive**
**Cupertino California 95014 (US)**
Inventor: **Lester, William Carl**
**14610 Blossom Hill Road**
**Los Gatos California 95030 (US)**
Inventor: **Michaelson, John Daniel**
**120 Adrian Place**
**Los Gatos California 95030 (US)**

(74) Representative: **Lewis, Alan John**
**IBM United Kingdom Patent Operations Hursley Park**
**Winchester, Hants, S021 2JN (GB)**

Courier Press, Leamington Spa, England

Bias sputter deposition apparatus and its method of use

This invention relates to sputtering processes and more particularly, to apparatus for coating by cathode sputtering.

In the sputter etching and deposition of material, it is sometimes desirable to coat both sides of a substrate. Because of the necessity to apply a voltage to the substrate and to cool the substrate during the sputtering operation, only one side of the substrate was normally coated at a time since this permitted the substrate to be fastened to a base plate which was cooled by a cooling liquid and which was connected to a voltage source. The mounted substrate was then placed into a vacuum chamber where the pressure was lowered and a rare gas was admitted to sustain the plasma after the voltages are applied between the sputter cathode and the substrate.

U.S. Patent 3,979,273 proposes to sputter deposit both sides of a substrate by rotating the substrate between targets in the vacuum chamber. The substrate is in the shape of a cylinder which therefore requires that the substrate be rotated during the deposition process. There is no disclosure in this patent of a means for depositing on both sides of a substrate at one time without rotation by supporting a substrate through the centre of the cathode targets.

U.S. Patent 3,741,886 suggests a cathode/ target that is larger than the substrate to be coated. This patent is typical of the prior art where the substrate is supported by a platform table which supplies the cooling and power for operation of the sputter deposition.

U.S. Patent 4,073,262 suggests apparatus for the magnetic coating of magnetic disks consisting of a means for coating both sides of a disk by spraying the coating material onto both sides of the substrate at one time.

U.S. Patent 3,189,535 suggests a dual cathode target system for coating a spherical substrate. The sphere is supported on one end and rotated within for complete coverage.

An IBM Technical Disclosure Bulletin entitled "Coating Magnetic Storage Disks", April 1969 at page 1611 discloses apparatus consisting of two plain parallel cathodes between which a magnetic disk substrate fixed on a rotating anode turntable is disposed. Several disks can be mounted on the turntable and can be moved between several cathode systems having different target materials.

U.S. Patent 3,878,085 to Corbani; Chapin, The Planar Magnetron, Vacuum Technology Research/Development, January 1974, pages 37—40; and Cormia et al., Magnetically Enhanced High-Rate Sputtering, Proceed. Electro-Chemical Soc., September 1974 are of interest with respect to magnetically-enhanced sputtering.

The invention provides sputtering apparatus for sputter coating a planar substrate, said apparatus comprising a sputtering chamber in which a sputtering environment can be established; means for supporting the substrate within the chamber, said means comprising two aligned opposed ram structures which are relatively movable to clamp the substrate therebetween; two spaced, aligned sputter cathodes having opposed surfaces facing the two planar surfaces of the clamped substrate and of at least the same area and shape as the substrate surfaces; passages in the ram structures for the circulation of cooling fluid to portions thereof which contact the substrate to conduct heat from the substrate; means for establishing both A.C. and D.C. voltages between the substrate and the cathodes; and a conducting ring-element around but spaced from the periphery of the substrate, the spacing between the ring-element and the periphery of the substrate being such that the inside diameter of the ring is within the Crooke's dark space of the substrate and plasma glow is suppressed.

Preferably the substrate and cathodes are of annular shape and the ram structure comprises tubular stems passing outwardly through the central apertures of the cathodes and enlarged heads providing annular clamping surfaces abutting the inner marginal edge portion of the substrate.

The invention will now be more particularly described with reference to the accompanying drawings, in which:—

FIGURE 1 is a cross-sectional view with certain parts broken away of a cathode sputtering system or apparatus embodying the present invention.

FIGURE 2 is a view showing the preferred hub support arrangement for the substrate and part of the surrounding apparatus.

FIGURE 3 is a cross-sectional view showing a portion of a shaped glow suppression ring.

FIGURE 4 is a circuit diagram of the system.

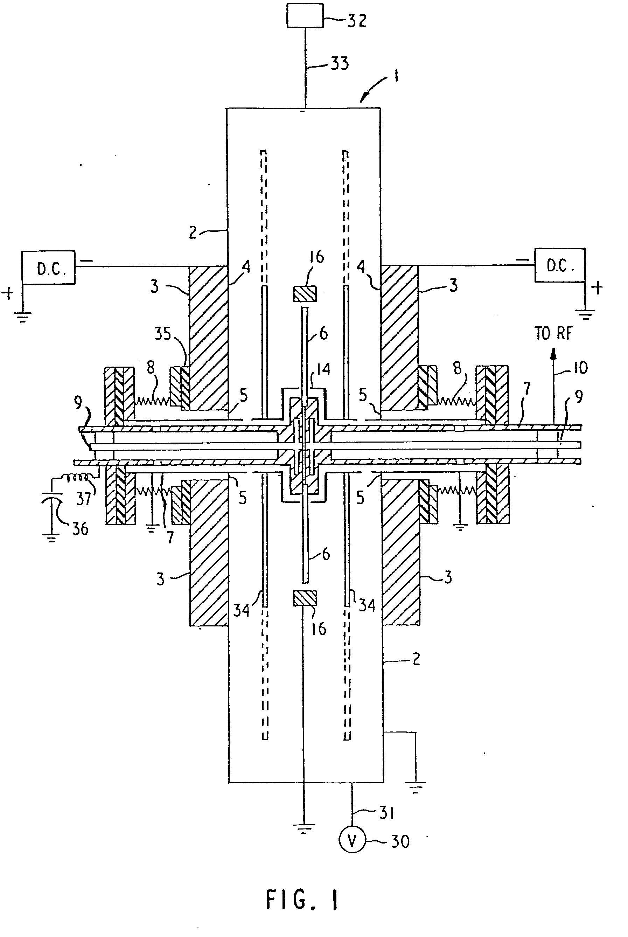

Figure 1 is a cross-sectional view with certain parts broken away of a cathode sputtering system embodying the present invention. The vacuum chamber 1 of the sputtering apparatus is enclosed by the horizontal and vertical walls 2 and the facing surfaces 4 of the two cathodes 3. The vacuum chamber 1 can be evacuated by operation of vacuum pump 30, which is connected to the vacuum chamber 1 via conduit 31, and gas capable of supporting the sputtering operation is admitted in the vacuum chamber 1 via conduit 33 from gas source 32. Example of some suitable gases include the inert gases such as argon, krypton, and helium, argon being the preferred gas. The gas is generally employed in amounts sufficient to provide a pressure of about 1 to about 50 microns in the vacuum chamber 1.

Two sputtering cathodes 3 are provided. The cathodes 3 are D.C. planar magnetically enhanced cathodes. As illustrated, the two cathodes 3 are mounted parallel to each other. The facing surface 4 of each cathode 3 comprise the material which is to be sputtered onto the substrate 6 to be coated. Examples of some suitable materials to be sputtered include metals or alloys such as stainless steels, tungsten, and molybdenum. Each cathode 3 includes a centrally located cutout portion 5.

A typical arrangement comprises a large circular cathode having a diameter of about 46 cm (18 inches) with about a $7\frac{1}{2}$ cm (3-inch) diameter centrally located cutout. The magnetic means for enhancing the sputtering about the cathode 3 can be included within the cathodes 3 and comprise a plurality of concentric magnetic rings, for example 3 rings. In addition, the cathodes 3 are water cooled. The temperature of the cooling water would usually be about 15°C as it enters the system and about 20—30° upon exiting. It is preferred that the magnetic and other portions of each of the cathodes 3 be formed as a one piece element rather than two separate parts affixed together such as by bolting in view of the enhanced cooling achievable by the preferred arrangement.

The cathodes 3 are of a dimension (e.g., outside diameter) which is at least equal to the dimension (e.g., outside diameter) of the substrate to be coated and preferably are larger than the substrate to be coated. In a typical embodiment, the outside diameter of each cathode 3 is about 46 cm (18 inches) and the outside diameter of the substrates 6 to be coated is about 36 cm (14 inches).

Through the centrally located cutout 5 of each cathode is inserted a ram means 7. The ram means slide in a direction perpendicular to the facing surfaces 4 of the cathodes 3. Numeral 8 designates a slidable bellows-type seal between each of the ram means and the cathodes 3. The ram means are capable of movement so as to contact the disk shaped substrate 6 to be coated and to support the substrate therebetween as illustrated in Figure 1. Pads 35 insulate the cathodes 3 from the ram means.

Any suitable arrangement can be employed to move the rams 7 back and forth through the cutout portions of the cathodes 3. Examples are lead screw means, hydraulic cylinders and pneumatic air cylinders. In a typical arrangement, the clearance between the cathode cutout portion and the ram is about 1.25 cm (1/2 inch).

The ram means 7 include conduits 9 for the circulation of a cooling fluid such as water. The water is fed through the hub portions of the rams 7 which contacts the substrate 6. The temperature of the coolant water is conveniently about 15°C when it enters and about 20—30°C upon exiting the ram. When the ram means are in contact with the substrate to be coated, the ram means will act as a heat sink and control the temperature of the substrate 6. The temperature of the substrate during the sputtering should be no more than 250°C to prevent warpage of the substrate, and is generally between 100°C and 250°C.

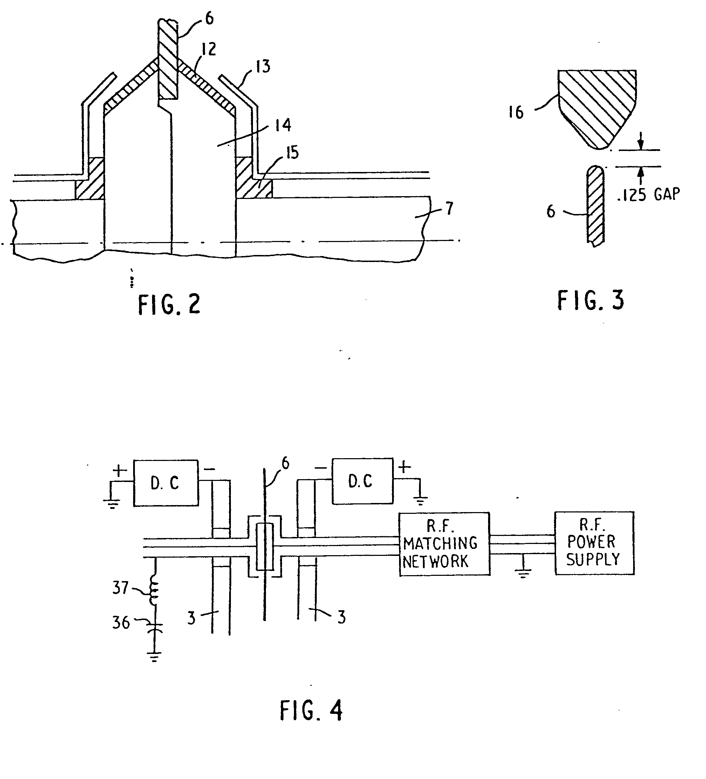

The rams 7 are formed of an electrically conductive material and preferably are formed of the same material as the coating to be sputtered onto the substrate 6. One of the rams is connected to a radio frequency power generator (see Fig. 4) via connector 10 while the other ram is connected to ground via a 2 KPF variable capacitor 36 and a water cooled inductor 37 to ensure that both rams are at the same electrical potential. Examples of some suitable materials for the rams include copper, aluminium, and stainless steel.

Figure 2 illustrates a preferred hub design of the ram means. The Fig. 2 hub design is preferred since it eliminates a problem which would occur when employing the type of configuration illustrated in Figure 1. This problem arises if there is a failure to suppress sputtering of hub material onto the disc. The improved hub configuration is fabricated from aluminium, which provides enhanced thermal and electrical conductivity to the substrate to be coated, and its peripheral surface tapers to form an angle, preferably about 45°, between the hub periphery and the substrate surface as compared to a 90° angle shown for the hub design in Figure 1.

The hub 14 is covered with a consumable and replaceable sleeve or collar 12 which can be fabricated from a material such as aluminium, magnesium, or stainless steel. Stainless steel is preferred since it is an acceptable contaminant in the sputtering process and does not significantly affect the thermal or electrical conductivity.

The ram ground shield 13 (Fig. 2) is spaced from the surface of the substrate 6. This positioning of the hub ground shield 13 distorts the Crookes dark space with resultant effects on sputter, etch and bias rates over the hub but not on the substrate surface. If the ground shield is retracted away from the substrate, a portion of the hub surface would be sputtered.

The preferred hub design produces uniform sputter etching and biasing of the substrate 6 up to the very edge of the hub assembly. This is compared to sputtering when the hub design demonstrated in Figure 1 is employed which results in a distortion of Crookes dark space by the hub ground shield which produces about a 1.25 cm (one-half inch) wide band around the hub where a significant reduction in sputter etch or bias rate occurs. Located between the hub 14 and ground shield 13 is an electrical insulator 15.

Around the periphery of the substrate 6 is provided a means 16 for suppressing plasma glow. The inside diameter of the glow suppression ring 16 is located within the Crookes dark space of the substrate. Without the glow suppression ring around the periphery of the substrate, it was observed that R.F. sputter, etching and biasing occurred only around the outside diameter of the substrate in a band approximately one centimeter wide. The remainder of the substrate surface showed negligible effects of the substrate bias power.

A 2.54 cm (one-inch) substantially square cross-sectional grounded aluminium glow suppression ring 16 was provided around the periphery of the substrate and extending into the Crookes dark space surrounding the substrate.

The ring 16 should not have any sharp edges. The size of the ring is not crucial. The important parameter is that the inside diameter of the ring be located within the Crookes dark space of the substrate. For a typical substrate of about 36 cm (14 inches) the gap between the inside diameter of the ring 16 and the outside diameter of the substrate 6 is about 0.32 cm (1/8 inch) to about 0.64 cm (1/4 inch). As the size of the substrate 6 changes, so will this gap so as to maintain the inside diameter of the ring within the Crookes dark space of the substrate.

A spacing, such as about a 0.32 cm (0.125 inch) spacing, is maintained between the substrate outer diameter and the inner diameter of the glow suppression ring 16. Use of this suppression ring resulted in sputter, etching and biasing of the entire surface of the substrate 6 with the exception of only a one centimeter wide band around the outside diameter. A portion of the substrate where the hub contacts the substrate was discoloured somewhat. In order to coat even this small additional portion of the substrate, a shaped cross-section grounded glow suppression ring as illustrated in Figure 3 was employed. This preferred configuration which is about a 45° taper beginning from about the middle of the square ring resulted in sputter etching of the entire surface of the substrate. The ring has no sharp edges and tapers to a width which is about equal in thickness to the substrate. The plane of the substrate and the plane of the glow suppression ring must be aligned so that the suppression ring is around the periphery of the substrate.

As discussed hereinabove, the presence of a glow suppression ring around the periphery of the substrate is fundamental to the successful practice of the present apparatus. Heretofore this has not been appreciated. For instance, attempts to sputter/etch both sides of the substrate without employing a glow suppression ring in the configuration of the present invention were not successful. In particular, employing about 3 kilowatt forward power, about a 175 watt reflected power, with 10 microns of argon pressure and a total etch time of 60 minutes resulted in sputtering of only about 0.96 cm (3/8 inch) at the outer diameter of the substrate along with some discolouration and slight etching around the area contacting the hub of the ram which was caused by the hub glow suppression assembly. Without the presence of the glow suppression ring, there is insufficient uniformity of R.F. power on the substrate in order to sputter etch to any significant degree.

On the other hand, when employing a square cross-sectional glow suppression ring as illustrated in Figure 1 and etching for about 60 minutes under about 10 microns argon pressure at 3 kilowatt forward power, the substrate was visibly sputter etched over the entire surface except for only the outer one centimeter of the radius and about 1.3 centimeters wide area of discolouration around the inside diameter at the place where the hub of the ram contacts the substrate.

The use of a glow suppression ring of the configuration illustrated in Figure 3 results in sputter etching of the entire surface of the substrate except for the portion around the inside diameter due to the effect of the hub of the ram. When using the preferred hub configuration of Figure 2 as discussed hereinabove, this effect of the hub is minimized.

If desired, preselected portions of the substrate can be masked or shielded from sputter etching by placing (e.g., such as by bolting) a metallic mask segment onto the desired preselected portion of the substrate. This can be done without affecting the cathode current density.

Figure 4 shows the electrical circuitry by which the necessary R.F. and D.C. potentials are applied to the disc substrate 6 and the cathodes 3. As shown the negative terminals of suitable D.C. power supplies are connected to the cathodes 3 and the R.F. power supply is connected through a matching network to the right hand ram means. Symmetrical deposition on each side of the disk is accomplished by regulating the D.C. power so that the sputtering rates of the two targets are equal and then turning the R.F. bias supply to achieve the desired film thickness.

In the operation of the foregoing system, some self-sustained discharges were noted forming on the surfaces of the system coated with sputter etched substrate material. These discharges however can be readily eliminated by slowly "burning in" the system surface without the substrate being present. For instance, about 5 to 10 minutes of "burn in" is suitable for such purpose to achieve stable R.F. sputter etching. In particular, self-sustained discharges can be eliminated, in the R.F./D.C. system with the application of 300 to about 600 $V_{DC}$ at about 2 to about 14 amperes to either or both of the planar cathodes. After about 5 minutes of controlled, measurable R.F. sputter etching in this manner, the D.C. potential can be removed and no further discharges will occur.

The sputter apparatus can optionally include shutters 34, illustrated in full lines in Figure 1 in their closed position, for the above purpose. These shutters can be used to permit simultaneous sputter etching of the substrate to remove contamination and D.C. target presputtering. The shutters can be moved to an open position, shown in broken lines in Figure 1, in which position the system can be used for sputtering the disc. The shutter plates 34 are retracted to their open position by an external motor drive during the sputter deposition and are in place only during pre-sputter and sputter/etch to shield the disc. Typical operating conditions of the apparatus of the present invention include D.C. power of about 1—15 amps, and about 300—600 volts; R.F. power of about 1—3 Kw., sputter gas pressure of about 1—50 microns; substrate temperature of about 100—250°C; sputtering time up to about 30 minutes; and rate of deposition of about 500 to about 2000 angstroms/minute to provide about 5—20 microns thick films on both sides of the substrate.

Some advantages achieved by the present invention include the ability for R.F. bias and D.C. sputtering in the same chamber on both sides of the substrate simultaneously, as well as a significant decrease is deposition time of at least a factor of about three over that achieved by the use of standard sputtering targets and substrate rotation. Furthermore, the bias sputtering allows better substrate coverage in one coat and gives higher density film. The present invention also eliminates the need for rotation of the substrate for coating the entire substrate surface. It has further been noted that the present invention results in a lower pinhole count in deposited films as a result of R.F. biasing.

## Claims

1. Sputtering apparatus for sputter coating a planar substrate, said apparatus comprising a sputtering chamber (1) in which a sputtering environment can be established; means for supporting the substrate within the chamber, said means comprising two aligned opposed ram structures (7) which are relatively movable to clamp the substrate (6) therebetween; two spaced, aligned sputter cathodes (3) having opposed surfaces (4) facing the two planar surfaces of the clamped substrate (6) and of at least the same area and shape as the substrate surfaces; passages (9) in the ram structures for the circulation of cooling fluid to portions thereof which contact the substrate to conduct heat from the substrate; means (Fig. 4) for establishing both A.C. and D.C. voltages between the substrate and the cathodes; and a conducting ring-element (16) around but spaced from the periphery of the substrate (6), the spacing between the ring-element (16) and the periphery of the substrate (6) being such that the inside diameter of the ring is within the Crooke's dark space of the substrate and plasma glow is suppressed.

2. Apparatus as claimed in claim 1, in which the substrate (6) and cathodes (3) are of annular shape and in which the ram structures (7) comprise tubular stems passing outwardly through the central apertures (5) of the cathodes (6) and enlarged heads providing annular clamping surfaces abutting the inner marginal edge portion of the substrate (6).

3. Apparatus as claimed in claim 2, in which the peripheral surface of each of the ram heads (14, Fig. 2) is tapered to increase in diameter towards the substrate.

4. Apparatus as claimed in claim 3, in which the peripheral surface of each of the ram heads (14, Fig. 2) is provided by a layer (12) of the same material as the material to be sputter deposited from the cathodes whereby contamination of the deposit is reduced.

5. Apparatus as claimed in claim 2, 3 or 4 in which the head and the portion of the stem of each ram structure (7) within the chamber (1) is contained within a co-axial tubular housing insulated from the structure and maintained in use at a fixed potential (ground).

6. Apparatus as claimed in any one of claims 1 to 5, in which the ring-element (16; Fig. 3) is maintained in use at a fixed potential (ground) and tapers in cross-section towards the substrate to have an edge thickness substantially equal to the thickness of the substrate (6).

7. Apparatus as claimed in any one of claims 1 to 6, in which the A.C. establishing means (Fig. 4) comprise an R.F. power supply unit and an R.F. impedance matching network supplying power to a tuned circuit comprising the ram structures, the substrate, an inductance and a capacitance.

8. Apparatus as claimed in any one of claims 1 to 7, in which the D.C. establishing means comprise two D.C. power supply units having their positive sides connected to ground and their negative sides respectively connected to the two sputtering cathodes.

9. A method of using apparatus as claimed in claims 7 and 8, comprising adjusting the two D.C. power supplies so that the two sputtering rates are substantially equal and then tuning the R.F. bias supply to achieve the required thickness of deposit.

10. Apparatus as claimed in any one of claims 1 to 8, in which shutter means are provided between the surfaces of the cathodes, the shutter means being movable between closed positions in which they mask the substrate from the cathodes and open positions in which the substrate is exposed to the cathodes.

## Revendications

1. Appareil pour revêtir par pulvérisation un substrat plan, ledit appareil comportant une chambre de pulvérisation (1) dans laquelle un milieu de pulvérisation peut être établi; des moyens pour soutenir le substrat à l'intérieur de la chambre et qui comportent deux mâchoires alignées (7) qui se font face et qui sont mobiles l'une par rapport à l'autre pour serrer le substrat (6) entre-elles; deux cathodes de pulvérisation (3) alignées et séparées l'une de l'autre dont les faces opposées (4) sont disposées en regard des deux faces planes du substrat (6) ainsi serré et présentent au moins la même superficie et la même forme que les faces du substrat; des passages (9) ménagés dans les mâchoires pour permettre à un fluide de refroidissement de parvenir aux parties de celles-ci qui sont en contact avec le substrat afin de refroidir ce dernier; des moyens (figure 4) pour établir des tensions alternatives et des tensions continues entre le substrat et les cathodes; et un élément annulaire conducteur (16) qui entoure la périphérie du substrat (6) mais est séparé de celle-ci de telle sorte que le diamètre intérieur de l'anneau se trouve dans la zone sombre de Crookes du substrat et que la luminescence du plasma soit supprimée.

2. Appareil selon la revendication 1, caractérisé en ce que le substrat (6) et les cathodes (3) sont de forme annulaire et en ce que les mâchoires (7) comportent des tiges tubulaires qui s'étendent vers l'extérieur en traversant les ouvertures centrales (5) des cathodes (6) et des têtes surdimensionnées constituant des surfaces annulaires de serrage qui aboutent la zone centrale interne du substrat (6).

3. Appareil selon la revendication 2, caractérisé en ce que le diamètre de chacune des têtes (14, figure 2) des mâchoires augmente graduellement en direction du substrat.

4. Appareil selon la revendication 3, caractérisé en ce que la surface périphérique de chacune des têtes (14, figure 2) des mâchoires est pourvue d'une couche (12) d'un matériau identique à celui qui doit être déposé par pulvérisation depuis les cathodes, ce qui permet de réduire la contamination du dépôt.

5. Appareil selon la revendication 2, 3 ou 4, caractérisé en ce que la tête et la partie de la tige de chacune des mâchoires (7) qui se trouve à l'intérieur de la chambre (1) sont contenues dans un logement tubulaire coaxial qui est isolé de la mâchoire et maintenu à un potentiel fixe (masse) en cours d'utilisation.

6. Appareil selon l'une quelconque des revendications 1 à 5, caractérisé en ce que l'élément annulaire (16, figure 3) est maintenu en cours d'utilisation à un potentiel fixe (masse) et en ce que son diamètre augmente graduellement en direction du substrat de telle sorte que son bord présente une épaisseur pratiquement égale à celle du substrat (6).

7. Appareil selon l'une quelconque des revendications 1 à 6, caractérisé en ce que les moyens (figure 4) qui permettent d'établir un courant alternatif comportent une alimentation HF et un réseau HF d'équibrage d'impédance alimentant un circuit accordé qui comporte les mâchoires, le substrat, une inductance et une capacité.

8. Appareil selon l'une quelconque des revendications 1 à 7, caractérisé en ce que les moyens qui permettent d'établir un courant continu comportent deux alimentations en courant continu dont les bornes positives sont reliées à la masse et dont les bornes négatives sont respectivement connectées aux deux cathodes de pulvérisation.

9. Procédé d'utilisation d'un appareil selon les revendications 7 et 8, caractérisé en ce qu'il consiste à régler les deux alimentations en courant continu de telle sorte que les deux vitesses de pulvérisation soient pratiquement égales, puis à accorder l'alimentation HF de polarisation de manière à obtenir un dépôt présentant l'épaisseur requise.

10. Appareil selon l'une quelconque des revendications 1 à 8, caractérisé en ce que des moyens d'obturation sont disposés entre les faces des cathodes et peuvent se déplacer entre des positions fermées, dans lesquelles ils cachent le substrat aux cathodes, et des positions ouvertes, dans lesquelles le substrat est exposé aux cathodes.

**Patentansprüche**

1. Kathodenzerstäubungsvorrichtung zum Bedecken einer ebenen Oberfläche mittels Kathodenzerstäubens wobei die Vorrichtung folgende Merkmale aufweist: eine Kathodenzerstäubungskammer (1) in welcher Verhältnisse erzeugt werden können, unter welchen Kathodenzerstäubung stattfindet, Mittel um das Substrat in der Kammer zu fixieren, wobei diese Mittel aus zwei zueinander ausgerichteten, einander gegenüberliegenden Stempelstrukturen (7) bestehen, welche relativ zueinander beweglich sind, so daß zwischen ihnen das Substrat (6) eingeklemmt werden kann, zwei voneinander getrennte, und zueinander ausgerichtete Kathodenzerstäubungskathoden (3), deren einander gegenüberliegende Oberflächen den beiden planaren Oberflächen des eingeklemmten Substrats (6) zugekehrt sind und mindestens dieselbe Größe und dieselbe Gestalt wie die Substratoberflächen haben, Durchgänge (9) in den Stempelstrukturen, um eine Kühlflüssigkeit zu den Bereichen der Stempelstruktur, welche Kontakt mit dem Substrat haben, zu bringen und dann von dort wieder wegzutransportieren, um Wärme von dem Substrat abzuleiten, Mittel (Fig. 4), um sowohl Wechsel- als auch Gleichspannungen zwischen dem Substrat und den Kathoden aufrechtzuerhalten, und ein leitfähiges Ringelement (16), welches den äußeren Rand des Substrats (6) umgibt, aber einen Abstand von ihm hat, wobei dieser Abstand zwischen dem Ringelement (16) und dem äußeren Rand des Substrats (6) so festgelegt wird, daß der innere Durchmesser des Rings sich innerhalb des Crookeschen Dunkelraums des Substrats befindet und das Plamaglimmen unterdrückt wird.

2. Vorrichtung wie im Anspruch 1 beansprucht, in welcher das Substrat (6) und die Kathoden (3) eine ringförmige Form haben und bei welcher die Stempelstrukturen (7) aus rohrförmigen Stangen, welche nauch außen durch die zentralen Öffnungen (5) der Kathoden (3) durchgeführt sind, und aus vergrößerten Köpfen bestehen, welche ringförmige, klemmende Oberflächen aufweisen, welche am inneren Randbereich des Substrats (6) anliegen.

3. Vorrichtung wie im Anspruch 2 beansprucht, bei welcher die äußere Oberfläche der beiden Stempelköpfe (14, Fig. 2) eine kegelförmige Gestalt haben, so daß sich der Kopfdurchmesser in Richtung des Substrats vergrößert.

4. Vorrichtung wie im Anspruch 3 beansprucht, bei welcher die äußere Oberfläche der beiden Stempelköpfe (14, Fig. 2) mit einer Schicht (12) versehen ist, welcher aus dem selben Material besteht, welches mittels Kathodenzerstäubung aufgewachsen werden soll, so daß eine Verunreinigung des aufgewachsenen Materials vermindert wird.

5. Vorrichtung wie in den Ansprüchen 2, 3 order 4 beansprucht, bei welcher die Köpfe und die Teile der Stangen der beiden Stempelstrukturen (7) welche sich innerhalb der Kammer (1) befinden, in einem koaxialen rohrförmigen Gehäuse eingeschlossen sind, welches von den Strukturen isoliert ist und in Betrieb auf einem festgelegten Potential (Erde) liegt.

6. Vorrichtung wie in irgendeinem der Ansprüche 1 bis 5 beansprucht, bei welcher das Ringelement (16, Fig. 3) in Betrieb auf einem festgelegten Potential (Erde) gehalten wird und welches einen sich in Richtung des Substrats verjüngenden Querschnitt hat, so daß es am Rand eine Dicke hat, welche im wesentlichen gleich der Dicke des Substrats (6) ist.

7. Vorrichtung wie in irgendeinem der Ansprüche 1 bis 6 beansprucht, bei welcher die Mittel (Fig. 4) welche die Wechselspannung bereitstellen, aus einem Hochfrequenznetzgerät und einem Hochfrequenz-Impedanzanpassungsnetzwerk besteht, welches die Leistung für einen abgestimmten Stromkreis liefert, welcher aus den Stempelstrukturen, dem Substrat, einer Induktivität und einer Kapazität gebildet wird.

8. Vorrichtung wie in irgendeinem der Ansprüche 1 bis 7 beansprucht, in welcher die Gleichspannung erzeugenden Mittel aus zwei Gleichspannungsnetzgeräten bestehen, deren positive Seiten mit Erde verbunden sind und deren negative Seiten mit den beiden Kathodenzerstäubungskathoden verbunden sind.

9. Verfahren unter Verwendung einer Vorrichtung gemäß den Ansprüchen 7 und 8, bei welchem die beiden Gleichspannungsnetzgeräte so eingestellt werden, daß die beiden Kathodenzerstäubungsgeschwindigkeiten im wesentlichen gleich sind und daß dann die hochfrequente Vorspannungszuführung so abgestimmt wird, daß die erforderliche Dicke des aufwachsenden Materials erhalten wird.

10. Vorrichtung wie in irgendeinem der Ansprüche 1 bis 8 beansprucht, bei welcher zwischen der Oberflächen Kathodenblenden vorgesehen sind, deren Einstellung zwischen der geschlossenen Stellung, in welcher die Substrate von den Kathoden abgeschirmt ist, und der offenen Stellung, in welcher die Substrate unagbeschirmt den Kathoden gegenüber liegen, variiert werden kann.

**0 012 954**

FIG. I

FIG. 2

.125 GAP

FIG. 3

FIG. 4

2